# EUROPEAN PATENT SPECIFICATION

(11) **EP 3 010 321 B1**
(45) Date of publication and mention of the grant of the patent: **01.12.2021**
(21) Application number: 15189146.2
(22) Date of filing: 09.10.2015
(51) Int. Cl.: H05K 7/20

(54) **LIQUID COOLING SYSTEM FOR AN ELECTRONIC COMPONENT**
FLÜSSIGKEITSKÜHLSYSTEM FÜR EINE ELEKTRONISCHE KOMPONENTE
SYSTÈME DE REFROIDISSEMENT DE LIQUIDE POUR UN COMPOSANT ÉLECTRONIQUE

(30) Priority: 14.10.2014 IT PD20140270
(43) Date of publication of application: 20.04.2016
(73) Proprietor: Magneti Marelli S.p.A., 20011 Corbetta (MI) (IT)
(72) Inventor: TIZIANI, Roberto, I-20011 Corbetta, MILANO (IT); TAGLIAFERRI, Enrico, I-20011 Corbetta, MILANO (IT)
(74) Representative: Mitola, Marco

(56) References cited:
- DE-A1- 19 911 205
- FR-A1- 2 681 757
- US-A1- 2006 291 165
- US-A1- 2009 095 456
- US-A1- 2012 031 593
- US-A1- 2012 320 529
- US-A1- 2014 116 670

## Description

### FIELD OF APPLICATION

This invention relates to a liquid cooling system for an electronic component.

In the following, explicit reference will be made to an application in the automotive field without loss of generality; in fact, this invention is implemented for any type of electronic component provided with related cooling system.

### STATE OF THE ART

As is known, ever increasing use is being made in road vehicles of hybrid drive, which combines traditional internal combustion propulsion and related drive with the more innovative electric propulsion and related drive.

Electric drive requires the use of a rotating electric machine of the reversible type that can function both as a motor, by absorbing electricity and generating drive torque, and as a generator, i.e., absorbing mechanical energy and generating electricity. The electric machine, typically a three-phase synchronous type with permanent magnets, is mechanically connected or connectable to the drive wheels and is electrically connected to an electronic control unit containing an electronic converter power.

The electronic power converter comprises an electronic component that must be adequately cooled so as to avoid an excessive overheating of the semiconductor material contained in the electronic component, which would cause rapid deterioration.

The cooling system must also act as a thermostat so as to avoid as much as possible rapid and frequent temperature fluctuations that, due to the different coefficients of thermal expansion between the metallic materials and semiconductors that constitute the electronic component, generate a mechanical fatigue due to heat stress that can produce cracks and fatal ruptures of the electronic component with related disruptions of internal electrical connections.

So, for the purposes of a correct operation and durability of the electronic component, it is necessary that it be subjected to a continuous and effective cooling in order to avoid not only overheating but also sudden temperature changes for the reasons mentioned above.

### PRESENTATION OF THE INVENTION

In order to improve the cooling of the component, it is known for example to implement an electronic power converter for the control of an electric automotive machine having a metal exchanger plate provided with a first wall disposed in contact with the electronic component itself and a second wall, parallel and opposite to the first, as well as arranged in contact with a tank of cooling liquid, such as for example a solution of water with monoethylene glycol or other additive.

Typically, there is a tank of cooling liquid that is delimited at least partially by said second exchanger plate wall and is suitable to be crossed by a flow of cooling liquid. In addition, to the second wall it is associated a labyrinth or pattern of metal elements immersed in the cooling liquid. Said metal elements transmit the heat of the exchanger plate by conduction in correspondence of its anchor points (by welding) to the plate itself; furthermore, the metal elements, lapped by the flow of cooling fluid, increase the surface area of contact with the cooling fluid and allow greater removal of heat from the plate.

This solution involves a several drawbacks and limitations.

In fact, it is able to achieve an efficient cooling of the electronic component thanks to the considerable thermal exchange surface obtained by means of said metal labyrinth: in this way, despite the reduced size of the electronic component and its exchanger plate, it is possible to improve the heat exchange. On the other hand, the production of the labyrinth is very expensive because it requires rather complex and laborious machining; this machining has a high cost for both the initial tooling and the subsequent incremental production cost.

A further way for improving the cooling of the electronic component consists in also increasing the flow rate of cooling fluid sent to the component itself, so as to increase the thermal power removed, with equal physical/structural parameters of the parts of the component. However, there are constraints in terms of flow rate of fluid to be sent, related to the very small spaces available and the costs of the related recirculating pumps for the fluid itself.

From FR 2681757 A1 there is also known an alternative pattern to the above-mentioned labyrinth; this pattern comprises a plurality of metal strips equal to each other and folded according to regular rectangular, trapezoidal or sinusoidal geometric, shapes in order to increase the thermal exchange surface with the cooling fluid.

This document teaches to arrange such strips, equal to each other, in directions perpendicular to the flow of cooling liquid and to create a slight turbulence in the passage of the cooling fluid by means offsetting the metal strips with respect to the main direction of extension of the strips (perpendicular that of the flow of cooling fluid).

This slight offset is used to create a slight turbulence without affecting the free transverse passage cross section defined by said geometrical forms.

This solution, while being more economical than the labyrinth, is not always able to ensure a high and efficient removal of heat in all operating conditions and for all types of electronic components to be cooled.

In other words, this solution has limits in terms of cooling and therefore in the case of cooling high-power electronic components, is not able to ensure an efficient cooling unless, for example, the flow of cooling fluid is significantly increased. However, this increase is not always possible and entails further problems in terms of complexity and costs.

The document US2014116670A1 discloses a liquid cooling system according to the preamble of the independent claim 1.

Therefore, there is a need in the art to provide a liquid cooling system for electronic components that, at the same time, ensures thermal efficiency, even for high-power electronic components, reliability and low production and operating costs.

This need is satisfied by a cooling system according to claim 1.

### DESCRIPTION OF THE DRAWINGS

Further characteristics and advantages of this invention will be more understandable from the following description of its preferred and non-limiting examples of embodiments, wherein:

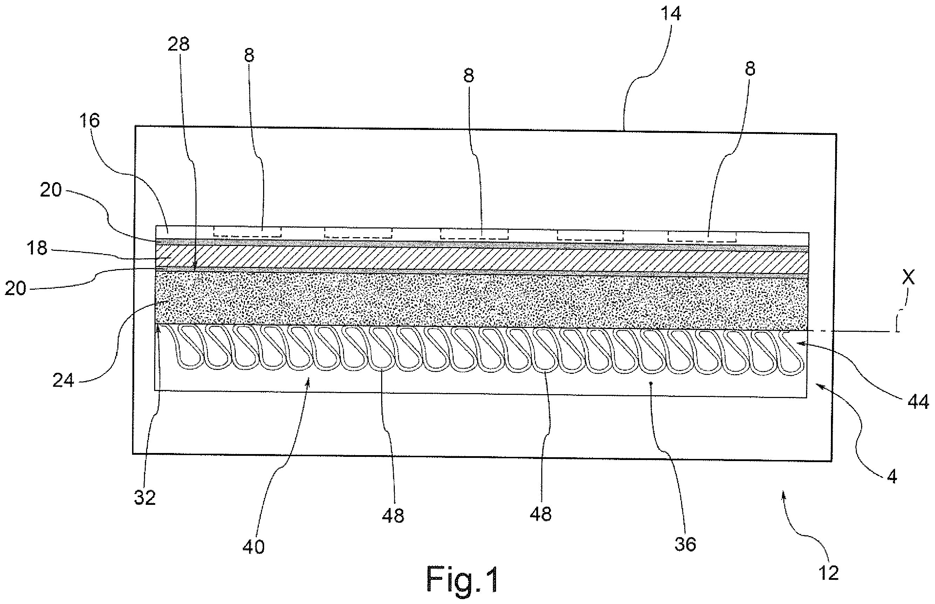

- Figure 1 is a schematic view of an electronic power converter, in particular for the control of an electric automotive machine, equipped with a liquid cooling system according to this invention;

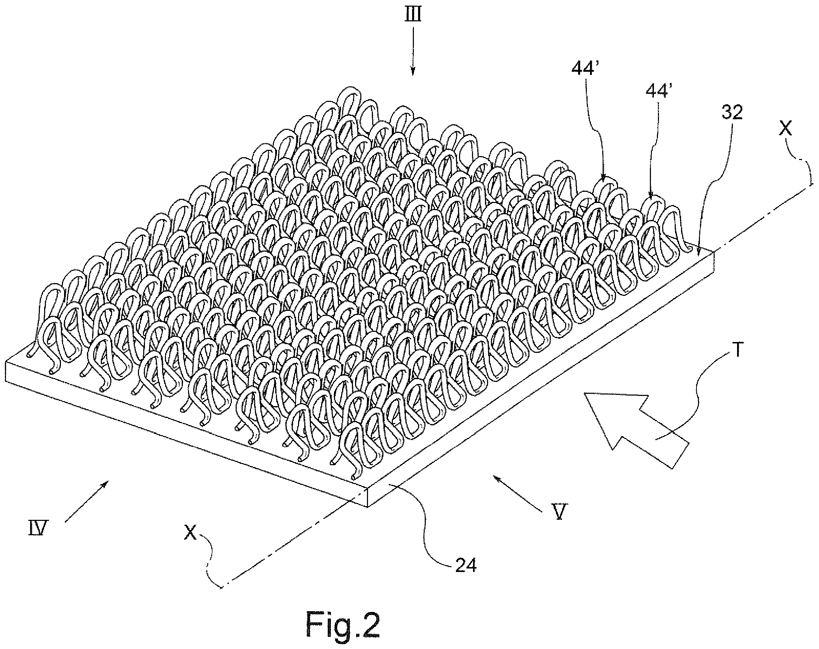

- Figure 2 is a perspective view of an exchanger plate of the cooling system of Figure 1;

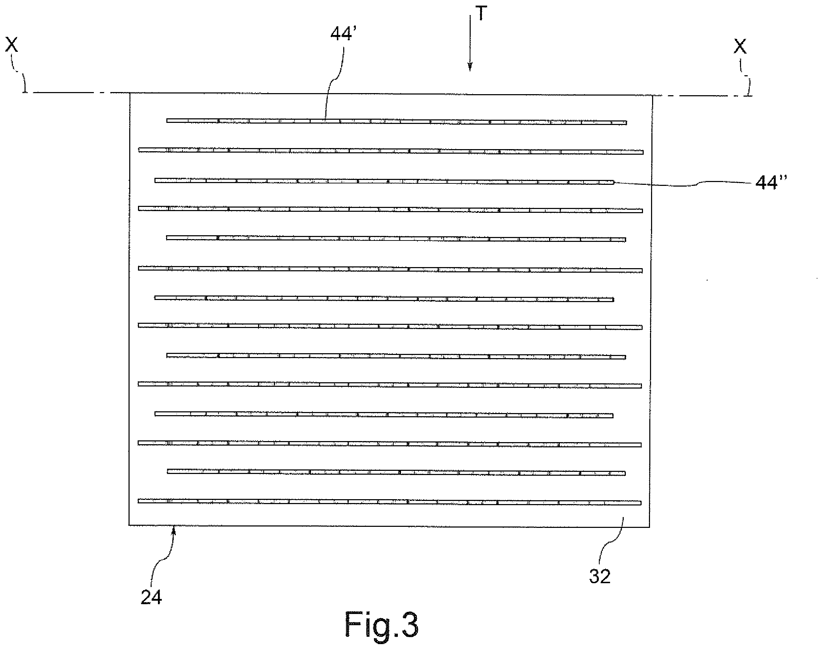

- Figure 3 is a plan view from above of the exchanger plate of Figure 2, from the side of the arrow III of Figure 2;

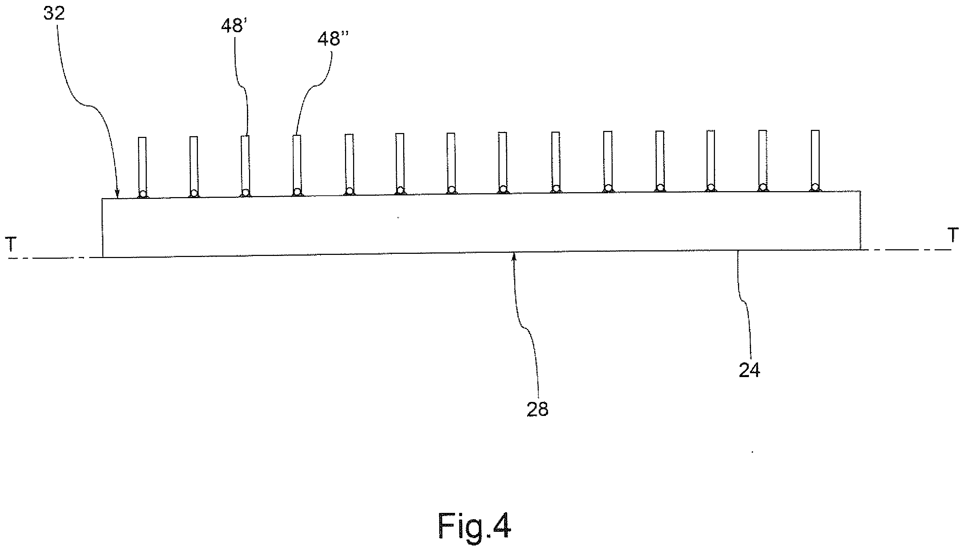

- Figure 4 is a plan view from the side of the exchanger plate of Figure 2, from the side of the arrow IV of Figure 2;

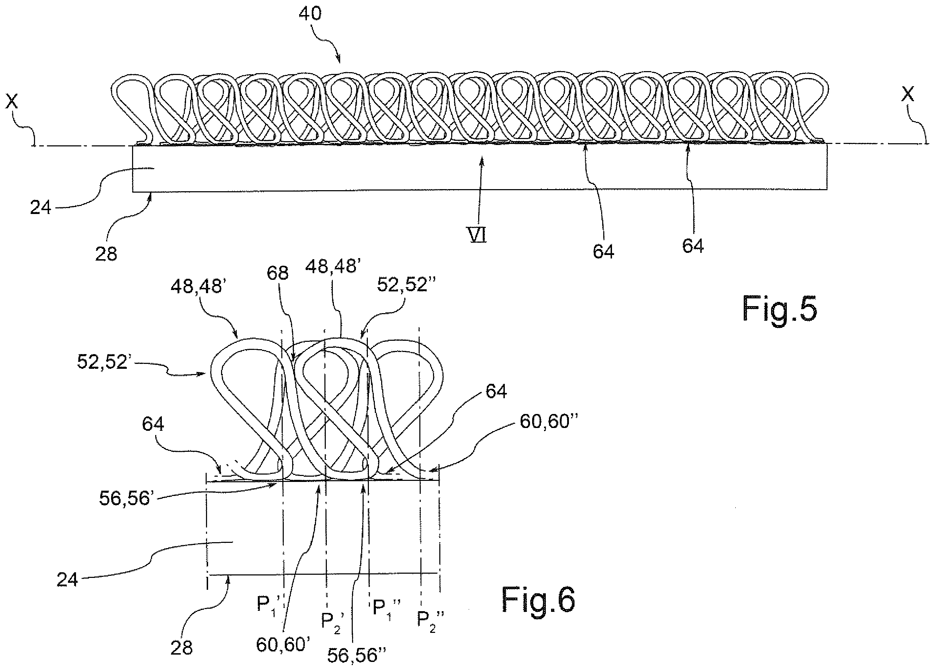

- Figure 5 is a plan view from the side of the exchanger plate of Figure 2, from the side of the arrow V of Figure 2;
- Figure 6 shows the enlarged detail VI of Figure 5;

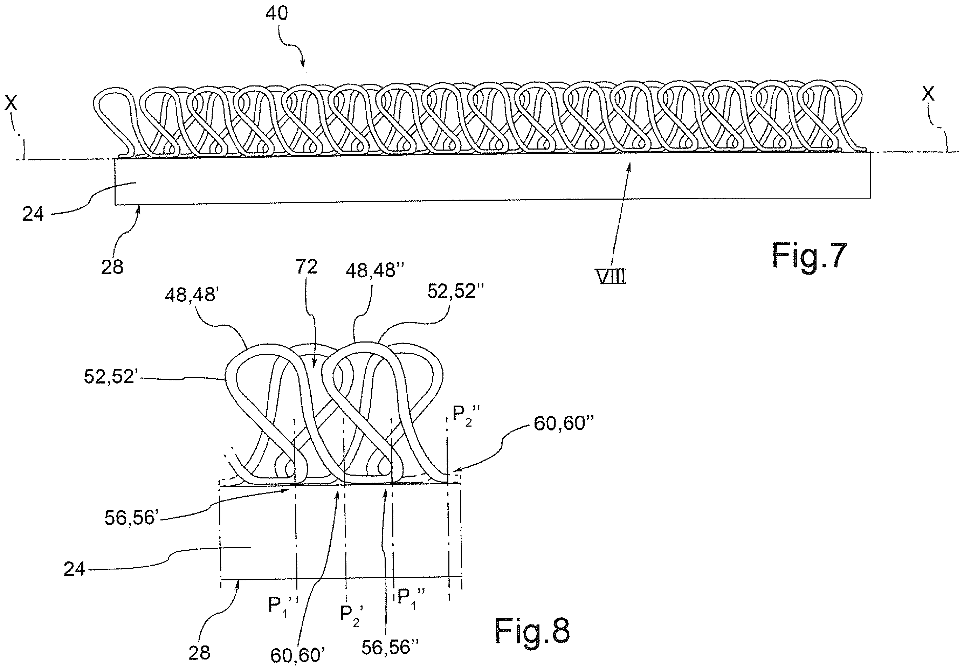

- Figure 7 is a side view of the exchanger plate of Figure 2, according to a further embodiment of this invention;
- Figure 8 shows the enlarged detail VIII of Figure 7;

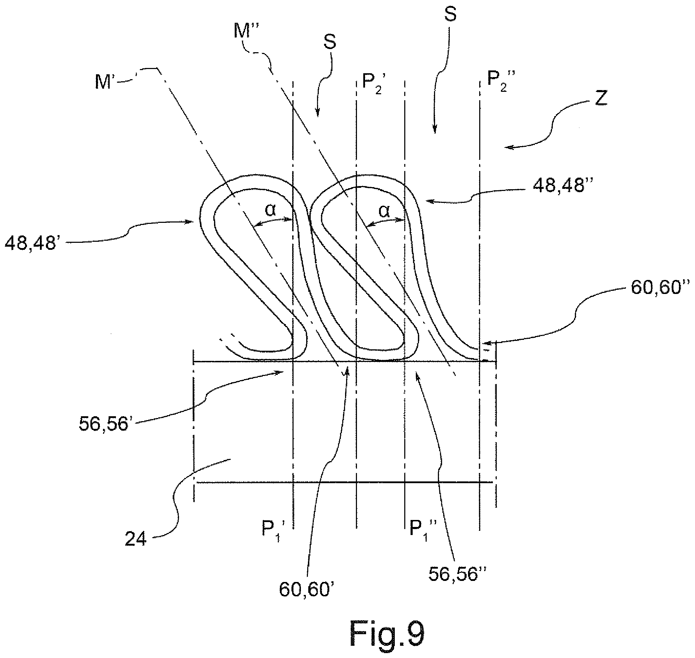

- Figure 9 shows a further enlarged detail of heat sink elements according to this invention.

The members, or parts of members, in common between the embodiments described below will be indicated with the same reference numbers.

### DETAILED DESCRIPTION

With reference to the above figures, reference number 4 globally indicates an overall schematic view of a liquid cooling system applied to at least one electronic component 8 according to this invention.

For the purposes of the scope of protection of this invention, the specific type of electronic component to which the cooling system is applied is not relevant; for example, but not exclusively, this invention is applied to an electronic component for automotive machine, such as an electronic power converter 12 for the control of an electric automotive machine.

In general, the electronic component 8 to be cooled may, in any case, be of any type, power and size.

For example, the electronic power converter 12 comprises a containment box 14 preferably metal, for example aluminium, inside which is disposed at least one electronic component 8, such as a battery of transistors, for the control of an associable electric machine (not shown).

For example, the electronic component 8 is realised on a substrate 16 of semiconductor material and is mounted on a support 18 of ceramic material.

According to an embodiment, between the substrate 16 of semiconductor material and the support 18 of ceramic material is interposed soldering material 20 to achieve a stable and permanent connection.

The liquid cooling system 4 has the function of removing the heat produced by dissipation inside the electronic component 8.

The liquid cooling system 4 for electronic component, comprises an exchanger plate 24, for example of parallelepiped shape; usually said exchanger plate 24 is made of copper and is nickel-plated with a thin layer of nickel.

The exchanger plate 24 comprises a first wall 28 suitable to be at least partially interfaced with the electronic component 8 to be cooled; for example, the first wall 28 is fixed to the support 18 of ceramic material of the electronic component 8 by interposition of soldering material 20.

The exchanger plate 24 also comprises a second wall 32, for example opposite to the first wall 28, and placed in contact with a bath of cooling liquid.

For example, as coolant liquid, water with added monoethylene glycol or other additive may be used.

The cooling system 4 will also be provided with a delivery and/or recirculation pump of the cooling liquid (not shown).

The cooling system further comprises a tank 36, delimited by the containment box 14, and connected to a hydraulic circuit (not shown), for example to circulate a flow of cooling fluid in the tank 36.

The tank 36 has an open side that is closed by said exchanger plate 24: in other words the tank 36 on one side of the second wall 32 of the exchanger plate 24, in such a way that this second wall 32 is lapped by the cooling fluid.

The cooling system comprises a plurality of heat sink elements 40, associated with said second wall 32 and influenced by the cooling fluid to dissipate heat.

The heat sink elements 40 are shaped according to regular patterns or strips 44 which extend parallel to a main extension direction X-X and which each comprise a plurality of loops 48.

Each loop 48 comprises a continuous curvilinear section 52 which extends projecting from a first to a second attachment end 56,60 attached to the second wall 32.

The heat sink elements 40 are made of thermally conductive metallic material, such as copper, preferably plated with nickel. Preferably, the heat sink elements 40 are made of the same material as the exchanger plate 24 since they have to conduct and transmit the heat of the electronic component received from the exchanger plate itself.

The attachment ends 56, 60 of the loops 48 are anchorage points of the loops 48 to the exchanger plate 24; said anchorages can preferably be obtained by welding, for example ultrasonic, but it is also possible to use thermally conductive adhesives.

According to a possible embodiment, two loops 48',48''consecutive with respect to the main extension direction X-X have respective attachment ends 60',56" coincident with each other so that the second attachment end 60' of a first loop 48' coincides with the first attachment end 56ʺ of a second consecutive loop 48ʺ.

According to a further embodiment, the attachment ends 60',56ʺ of two adjacent loops 48',48ʺ are connected by connection beads 64 in contact with the second wall 32.

One purpose of the connection beads 64 is to increase as much as possible the heat exchange by conduction between the heat sink elements 40 and the exchanger plate 24.

According to a possible embodiment, the heat sink elements 40 are at least partially made by means of a continuous conductor tape, folded in the form of a loop and attached to the second wall 32 at the first and second attachment ends 56,60 of each loop 48, wherein said tape has a quadrangular cross-section, preferably with bevelled or rounded edges.

The heat sink elements 40 can also be made of continuous conductor wire, folded in the form of a loop and attached to the second wall 32 at the first and second attachment ends 56,60 of each loop 48, wherein said wire has a curvilinear cross-section, for example circular or elliptical.

According to the invention, the continuous curvilinear section 52 is shaped so that, a first and a second plane P1,P2 being traced perpendicular to the second wall 32 passing respectively through said first and second ends 56,60, the continuous curvilinear section 52 extends at least partially outside the space S defined between said perpendicular planes P1,P2.

Preferably, the loops 48 are shaped so as to have a lumen for the passage of cooling fluid, measured on a projection plane Z perpendicular to the second wall 32 and parallel to the main extension direction X-X, which increases moving away from the second wall 32. In other words, the loops 48, net of possible slight local restrictions, tend on the whole to widen as one moves away from the exchanger plate 24, so as to offer less resistance to the passage of cooling liquid.

According to an embodiment, the continuous curvilinear section 52 extends partially in the space S defined by said two perpendicular planes P1,P2 and partially beyond the first of said perpendicular planes P1,P2.

Obviously, for the purposes of this invention, the concept of first plane P1 is for example only: said plane can be that indicated in the figures on the left side or even on the right side; the position of the plane is completely irrelevant, depending on the side of observation of the loops.

According to an embodiment, each loop 48 proves globally tilted laterally to the side of said first perpendicular plane P1.

According to the invention, a first and a second consecutive loop 48',48" of a same strip 44 are inclined in relation to the respective first perpendicular planes P1',P1" so that the continuous curvilinear section 52ʺ of the second loop 48ʺ intersects the second plane P2' of the first loop 48'.

For example, each loop 48 is substantially symmetrical in relation to a median plane M, said median plane M being inclined with respect to the second wall 32 on the side of the first plane P1.

Preferably said median plane M identifies with the second wall an angle α between 0 and 45 degrees.

Preferably, two loops 48',48ʺ adjacent in the main extension direction X-X have the same inclinations on the side of the respective first perpendicular planes P1',P1ʺ, said inclinations being identified by respective median planes M',M" of the loops 48',48ʺ.

Preferably, the loops 48 are arranged in rows, along regular and repetitive patterns or strips 44 parallel to the main extension direction X-X, wherein two adjacent strips 44',44" have loops 48 having continuous curvilinear sections 52, misaligned or offset to a transversal direction T perpendicular to said main extension direction X-X and parallel to the second wall 32.

Preferably, two adjacent strips 44',44" have loops 48 substantially symmetrical with respect to respective median planes M, wherein the median planes M of the loops 48 of said adjacent strips 44',44ʺ are inclined on opposite sides to the planes perpendicular to the second wall 32 and to the main extension direction X-X.

In this way, the continuous curvilinear sections 52 of loops belonging to adjacent strips 44',44" form intersections with respect to said transversal direction T.

According to a possible embodiment, the continuous curvilinear sections 52',52" of adjacent loops 48',48ʺ of the same row 44 touch at contact points 68, on the side opposite the second wall 32. These contact points 68 increase the heat exchange by conduction between the adjacent loops 48',48ʺ.

It is also possible to provide that the continuous curvilinear sections 52',52" of adjacent loops 48',48" of the same row or strip 44 do not touch, always identifying voids or gaps 72.

Preferably, the cooling system 4 comprises conveyors (not shown) for a flow of cooling liquid, in such a way that said cooling flow is conveyed parallel to the second wall and perpendicular to the main extension direction of the heat sink elements.

As can be appreciated from the description, this invention allows overcoming the drawbacks presented in the prior art.

In fact, the geometric arrangement of the heat sink elements allows having a significant turbulence to the cooling liquid passage that increases heat exchange and therefore the removal of heat of the electronic component.

Unlike the teachings of the prior art described above, this invention teaches to create multiple, repeated, and superimposed obstacles to the passage of the cooling fluid; In fact, it has been experimentally verified that if, on the one hand, such obstacles constitute a brake to the passage of the liquid and therefore a non-trivial loss of load, on the other, the heat exchange benefits considerably and the resulting removal of heat is much higher than that obtainable with the solutions of the known art.

In fact, the superimposed geometric arrangement of the exchanger allows, for the same volume and thus overall dimensions available, having a greater density of exchanger elements and therefore, a greater heat exchange surface on the whole.

So this invention, going against the teaching of the documents of the known art with particular reference to FR 2681757 A1 teaches to create repealed and superimposed obstacles to the passage of the cooling fluid so as to increase as much as possible both the interference to the passage of fluid, despite the increased loss of load and the turbulence of the flow itself. Therefore, it has been verified that the greater density of exchanger elements, with equal volume, and the greater resistance to the passage of the cooling fluid can enhance removal and therefore the thermostatisation of the electronic component.

In particular, thanks to the geometry of the exchanger elements of this invention, greater turbulence is created precisely at the second wall: in fact, the resistant section of the loops is minimal at the attachment ends and therefore at the second wall. Also the weld beads increase the exchange surface of the heat exchangers with the second wall and increase the turbulence of the fluid near the second wall.

As a whole, the turbulence of the cooling fluid is increased at the second wall since, on the one hand it narrows the passage section of the fluid and, on the other, obstacles or elements of discontinuity for the passage of the fluid created by the attachment ends and the connection beads of the consecutive loops are concentrated.

Experimental tests have shown that the increase of the density of exchanger elements (at equal volume), and of the turbulence of the cooling fluid prevail, from the point of view of heat exchange, over the increased resistance to the passage of the cooling fluid so as to improve the total heat exchange efficiency of the cooling system.

Furthermore, the cooling system of this invention is simple and economical to produce since the bending of the exchanger elements, whether wires or strips, can be performed with simple and economic machines. So both tooling costs and incremental production costs are low.

The cooling system of this invention is also particularly light because, as a whole, it uses a small amount of conductive material (metal) and provides a large percentage of voids compared to the filled spaces.

Finally, the cooling system of this invention has a modest hydraulic resistance with respect to the known complex labyrinth solutions.

A person skilled in the art, in order to satisfy contingent and specific needs, may make numerous modifications and variations to the cooling systems described above, all however contained within the scope of the invention as defined by the following claims.

## Claims

1. Liquid cooling system (4) for an electronic component (8), comprising:
- an exchanger plate (24) having a first wall (28) suitable to be at least partially interfaced with an electronic component (8) to be cooled and a second wall (32), placed in contact with a cooling liquid,
- a plurality of heat sink elements (40), associated with said second wall (32) and influenced by the cooling fluid to dissipate heat,
- wherein the heat sink elements (40) are shaped according to regular patterns or strips (44) which extend parallel to a main extension direction (X-X) and which comprise a plurality of loops (48),
- each loop (48) comprising a continuous curvilinear section (52) which extends projecting from a first to a second attachment end (56,60) attached to the second wall (32),
whereinthe continuous curvilinear section (52) is shaped so that, a first and a second plane (P1, P2) being traced perpendicular to the second wall (32) passing respectively through said first and second ends (56, 60), the continuous curvilinear section (52) extends at least partially outside the space (S) defined between said perpendicular planes (P1, P2),
**characterized in that**
a first and a second consecutive loop (48', 48") of a same regular pattern or strip (44) are inclined in relation to the respective first perpendicular planes (P1', P1ʺ) so that the continuous curvilinear section (52ʺ) of the second loop (48") intersects the second plane (P2') of the first loop (48').

2. Cooling system (4) according to claim 1, wherein the loops (48) are shaped so as to have a lumen for the passage of cooling fluid, measured on a projection plane (Z) perpendicular to the second wall (32) and parallel to the main extension direction (X-X), which increases moving away from the second wall (32).

3. Cooling system (4) according to any of the previous claims, wherein the continuous curvilinear section (52) extends partially in the space (S) defined by said two perpendicular planes (P1, P2) and partially beyond the first of said perpendicular planes (P1, P2).

4. Cooling system (4) according to any of the previous claims, wherein each loop (48) proves globally tilted laterally to the side of said first perpendicular plane (P1).

5. Cooling system (4) according to any of the previous claims, wherein each loop (48) is substantially symmetrical in relation to a median plane (M), said median plane (M) being inclined with respect to the second wall (32) on the side of the first plane (P1).

6. Cooling system (4) according to claim 5, wherein said median plane (M) identifies with the second wall (32) an angle (α) between 0 and 45 degrees.

7. Cooling system (4) according to claim 5 or 6, wherein two loops (48', 48")adjacent in the main extension direction (X-X) have the same inclinations on the side of the respective first perpendicular planes (P1', P1ʺ), said inclinations being identified by respective median planes (M', M") of the loops (48', 48ʺ).

8. Cooling system (4) according to any of the previous claims, wherein two loops (48', 48")consecutive in the main extension direction (X-X) have respective attachment ends (60', 56") coincident with each other so that the second attachment end (60') of a first loop (48') coincides with the first attachment end (56") of a second consecutive loop (48") .

9. Cooling system (4) according to any of the previous claims, wherein the attachment ends (60', 56") of two adjacent loops (48', 48 ") are connected by connection beads (64) in contact with the second wall (32).

10. Cooling system (4) according to any of the previous claims, wherein the loops (48) are arranged in rows, along regular and repetitive patterns or strips (44) parallel to the main extension direction (X-X), wherein two adjacent regular patterns or strips (44', 44") have loops (48) having continuous curvilinear sections (52), misaligned or offset to a transversal direction (T) perpendicular to said main extension direction (X-X) and parallel to the second wall ( 32).

11. Cooling system (4) according to any of the previous claims, wherein two adjacent regular patterns or strips (44', 44") have loops (48) substantially symmetrical with respect to respective median planes (M), wherein the median planes (M) of the loops (48) of said adjacent regular patterns or strips (44', 44") are inclined on opposite sides to the planes perpendicular to the second wall (32) and to the main extension direction (X-X).

12. Cooling system (4) according to any of the previous claims, wherein the continuous curvilinear sections (52', 52") of adjacent loops (48', 48 ") of the same row (44) touch at contact points (68), on the side opposite the second wall (32).

13. Cooling system (4) according to any of the previous claims, wherein the system comprises conveyors for a flow of cooling liquid, said cooling flow being conveyed parallel to the second wall (32) and perpendicular to the main extension direction (X-X) of the heat sink elements (40) .

14. Cooling system (4) according to any of the previous claims, wherein said heat sink elements (40) are at least partially made by means of a continuous conductor tape, folded in the form of a loop (48) and attached to the second wall (32) at the first and second attachment ends (56,60) of each loop (48), said tape having a quadrangular cross-section.

15. Cooling system (4) according to any of the previous claims, wherein said heat sink elements (40) are at least partially made by means of a continuous conductor wire, folded in the form of a loop (48) and attached to the second wall (32) at the first and second attachment ends (56, 60) of each loop (48), said wire having a curvilinear cross-section.

16. Electronic power converter (12) for the control of an electric automotive machine comprising an electronic component (8) to cool and a liquid cooling system (4) according to any of the claims from 1 to 15, wherein the electronic component (8) to cool is associated with the heat exchanger plate (24) of the liquid cooling system (4) .

## Patentansprüche

1. Flüssigkeitskühlsystem (4) für ein elektronisches Bauteil (8), umfassend:
- eine Austauscherplatte (24) mit einer ersten Wand (28), die geeignet ist, wenigstens teilweise mit einem zu kühlenden elektronischen Bauteil (8) gekoppelt zu sein, und einer zweiten Wand (32), die mit einer Kühlflüssigkeit in Kontakt steht,
- mehrere Wärmeableitelemente (40), die mit der zweiten Wand (32) verbunden sind und von der Kühlflüssigkeit beeinflusst werden, um Wärme abzuleiten,
- wobei die Wärmeableitelemente (40) nach regelmäßigen Mustern oder Streifen (44) geformt sind, die sich parallel zu einer Haupterstreckungsrichtung (X-X) erstrecken und die mehrere Schleifen (48) umfassen,
- wobei jede Schleife (48) einen kontinuierlichen krummlinigen Abschnitt (52) aufweist, der sich hervorstehend von einem ersten zu einem zweiten Befestigungsende (56, 60) erstreckt, die an der zweiten Wand (32) befestigt sind,
wobei der kontinuierliche krummlinige Abschnitt (52) so geformt ist, dass dann, wenn eine erste und eine zweite Ebene (P1, P2) senkrecht zu der zweiten Wand (32) durch das erste bzw. das zweite Ende (56, 60) gelegt werden, der kontinuierliche krummlinige Abschnitt (52) sich wenigstens teilweise außerhalb des zwischen den senkrechten Ebenen (P1, P2) definierten Raums (S) erstreckt,
**dadurch gekennzeichnet, dass**
eine erste und eine zweite nachfolgende Schleife (48', 48ʺ) desselben regelmäßigen Musters oder Streifens (44) in Bezug auf die jeweiligen ersten senkrechten Ebenen (P1', P1ʺ) so geneigt sind, dass der kontinuierliche krummlinige Abschnitt (52ʺ) der zweiten Schleife (48ʺ) die zweite Ebene (P2') der ersten Schleife (48') schneidet.

2. Kühlsystem (4) nach Anspruch 1, wobei die Schleifen (48) so geformt sind, dass sie ein Lumen für den Durchgang von Kühlflüssigkeit aufweisen, das mit der Entfernung von der zweiten Wand (32) zunimmt, gemessen auf einer Projektionsebene (Z) senkrecht zu der zweiten Wand (32) und parallel zu der Haupterstreckungsrichtung (X-X).

3. Kühlsystem (4) nach einem der vorangehenden Ansprüche, wobei sich der kontinuierliche krummlinige Abschnitt (52) teilweise in dem durch die beiden senkrechten Ebenen (P1, P2) definierten Raum (S) und teilweise über die erste der senkrechten Ebenen (P1, P2) hinaus erstreckt.

4. Kühlsystem (4) nach einem der vorangehenden Ansprüche, wobei jede Schleife (48) sich als allgemein seitlich zu der Seite der ersten senkrechten Ebene (P1) geneigt gestaltet.

5. Kühlsystem (4) nach einem der vorangehenden Ansprüche, wobei jede Schleife (48) bezüglich einer Mittelebene (M) im Wesentlichen symmetrisch ist, wobei die Mittelebene (M) bezüglich der zweiten Wand (32) zu der Seite der ersten Ebene (P1) geneigt ist.

6. Kühlsystem (4) nach Anspruch 5, wobei die Mittelebene (M) mit der zweiten Wand (32) einen Winkel (α) zwischen 0 und 45 Grad einschließt.

7. Kühlsystem (4) nach Anspruch 5 oder 6, wobei zwei in der Haupterstreckungsrichtung (X-X) benachbarte Schleifen (48', 48ʺ) gleiche Neigungen zu der Seite der jeweiligen ersten senkrechten Ebenen (P1', P1ʺ) aufweisen, wobei die Neigungen durch jeweilige Mittelebenen (M', Mʺ) der Schleifen (48', 48ʺ) bestimmt sind.

8. Kühlsystem (4) nach einem der vorangehenden Ansprüche, wobei zwei in der Haupterstreckungsrichtung (X-X) aufeinanderfolgende Schleifen (48', 48ʺ) jeweilige Befestigungsenden (60', 56") aufweisen, die zusammenfallen, so dass das zweite Befestigungsende (60') einer ersten Schleife (48') mit dem ersten Befestigungsende (56") einer zweiten nachfolgenden Schleife (48ʺ) zusammenfällt.

9. Kühlsystem (4) nach einem der vorangehenden Ansprüche, wobei die Befestigungsenden (60', 56") zweier benachbarter Schleifen (48', 48ʺ) durch Verbindungsstücke (64), die mit der zweiten Wand (32) in Kontakt sind, verbunden sind.

10. Kühlsystem (4) nach einem der vorangehenden Ansprüche, wobei die Schleifen (48) in Reihen entlang regelmäßiger und sich wiederholender Muster oder Streifen (44) parallel zu der Haupterstreckungsrichtung (X-X) angeordnet sind, wobei zwei benachbarte regelmäßige Muster oder Streifen (44', 44ʺ) Schleifen (48) mit kontinuierlichen krummlinigen Abschnitten (52) aufweisen, die in einer Querrichtung (T) senkrecht zu der Haupterstreckungsrichtung (X-X) und parallel zu der zweiten Wand (32) verschoben oder versetzt sind.

11. Kühlsystem (4) nach einem der vorangehenden Ansprüche, wobei zwei benachbarte regelmäßige Muster oder Streifen (44', 44ʺ) Schleifen (48) aufweisen, die bezüglich der jeweiligen Mittelebenen (M) im Wesentlichen symmetrisch sind, wobei die Mittelebenen (M) der Schleifen (48) der benachbarten regelmäßigen Muster oder Streifen (44', 44ʺ) bezüglich der Ebenen senkrecht zu der zweiten Wand (32) und zu der Haupterstreckungsrichtung (X-X) zu entgegengesetzten Seiten geneigt sind.

12. Kühlsystem (4) nach einem der vorangehenden Ansprüche, wobei sich die kontinuierlichen krummlinigen Abschnitte (52', 52ʺ) benachbarter Schleifen (48', 48ʺ) derselben Reihe (44) auf der der zweiten Wand (32) gegenüberliegenden Seite an Kontaktpunkten (68) berühren.

13. Kühlsystem (4) nach einem der vorangehenden Ansprüche, wobei das System Fördereinrichtungen für einen Strom von Kühlflüssigkeit umfasst, wobei der Kühlstrom parallel zu der zweiten Wand (32) und senkrecht zu der Haupterstreckungsrichtung (X-X) der Wärmeableitelemente (40) gefördert wird.

14. Kühlsystem (4) nach einem der vorangehenden Ansprüche, wobei die Wärmeableitelemente (40) wenigstens teilweise mittels eines kontinuierlichen Leiterbandes hergestellt sind, das in Form einer Schleife (48) gefaltet und mit den ersten und zweiten Befestigungsenden (56, 60) jeder Schleife (48) an der zweiten Wand (32) befestigt ist, wobei das Band einen viereckigen Querschnitt aufweist.

15. Kühlsystem (4) nach einem der vorangehenden Ansprüche, wobei die Wärmeableitelemente (40) wenigstens teilweise mittels eines kontinuierlichen Leiterdrahtes hergestellt sind, der in Form einer Schleife (48) gefaltet und mit den ersten und zweiten Befestigungsenden (56, 60) jeder Schleife (48) an der zweiten Wand (32) befestigt ist, wobei der Draht einen krummlinigen Querschnitt aufweist.

16. Elektronischer Leistungsumrichter (12) zur Ansteuerung einer elektrischen Kraftfahrzeugmaschine, der ein zu kühlendes elektronisches Bauteil (8) und ein Flüssigkeitskühlsystem (M) nach einem der Ansprüche 1 bis 15 umfasst, wobei das zu kühlende elektronische Bauteil (8) mit der Wärmetauscherplatte (24) des Flüssigkeitskühlsystems (4) gekoppelt ist.

## Revendications

1. Système de refroidissement par liquide (4) pour un composant électronique (8), comprenant :
- une plaque d'échangeur (24) ayant une première paroi (28) adaptée pour être au moins partiellement en contact avec un composant électronique (8) à refroidir, et une seconde paroi (32) disposée en contact avec un liquide de refroidissement,
- une pluralité d'éléments dissipateurs thermiques (40) associés à la seconde paroi (32) et influencés par le fluide de refroidissement pour dissiper de la chaleur,
- les éléments dissipateurs thermiques (40) étant formés selon des motifs réguliers ou lignes qui s'étendent parallèlement à la direction principale d'étendue (X-X) et qui comprennent une pluralité de boucles (48),
- chaque boucle (48) comprenant une partie continue curvilinéaire (52) qui s'étend en projection à partir d'une première jusqu'à une seconde extrémité de fixation (56, 60) attachée à la seconde paroi (32),
la partie continue curvilinéaire (52) étant formée de façon que, avec un premier et un second plan (P1, P2) tirés perpendiculairement à la seconde paroi (32) et passant respectivement par la première et la seconde extrémité (56, 60), la partie continue curvilinéaire (52) s'étend au moins partiellement en dehors de l'espace (S) défini entre les plans perpendiculaires (P1, P2),
**caractérisé en ce**
**qu'**une première et une deuxième boucle successives (48', 48") d'un même motif régulier ou d'une même ligne (44) sont inclinés par rapport au premier plan perpendiculaire respectif (P1', P1"), si bien que la partie continue curviligne (52") de la deuxième boucle (48") coupe le second plan (P2') de la première boucle (48').

2. Système de refroidissement (4) selon la revendication 1, **caractérisé en ce que** les boucles (48) sont formées de façon à avoir une ouverture pour le passage d'un fluide de refroidissement, mesurée sur un plan de projection (Z) perpendiculaire à la seconde paroi (32) et parallèle à la direction principale d'étendue (X-X), qui augmente en s'éloignant de la seconde paroi (32).

3. Système de refroidissement (4) selon l'une des revendications précédentes, **caractérisé en ce que** la partie continue curviligne (52) s'étend partiellement dans l'espace (S) défini par les deux plans perpendiculaires (P1, P2) et partiellement au-delà du premier des deux plans perpendiculaires (P1, P2).

4. Système de refroidissement (4) selon l'une des revendications précédentes, **caractérisé en ce que** chaque boucle (48) s'avère essentiellement penchée latéralement vers le côté du premier plan perpendiculaire (P1).

5. Système de refroidissement (4) selon l'une des revendications précédentes, **caractérisé en ce que** chaque boucle (48) est essentiellement symétrique par rapport à un plan médian (M), le plan médian (M) étant incliné, par rapport à la seconde paroi (32), du côté du premier plan (P1).

6. Système de refroidissement (4) selon la revendication 5, **caractérisé en ce que** le plan médian enferme avec la seconde paroi (32) un angle (α) entre 0 et 45 degrés.

7. Système de refroidissement (4) selon la revendication 5 ou 6, **caractérisé en ce que** deux boucles (48', 48") adjacentes dans la direction principale d'étendue (X-X) présentent les mêmes inclinaisons vers le côté des premiers plans perpendiculaires (P1', P1") respectifs, lesdites inclinaisons étant identifiées par les plans médians (M', M") respectifs de boucles (48', 48").

8. Système de refroidissement (4) selon l'une des revendications précédentes, **caractérisé en ce que** deux boucles (48', 48") successives dans la direction principale d'étendue (X-X) ont des extrémités de fixation (60', 56") respectives coïncidant l'une avec l'autre, si bien que la deuxième extrémité de fixation (60') d'une première boucle (48') coïncide avec la première extrémité de fixation (56") d'une deuxième boucle successive (48").

9. Système de refroidissement (4) selon l'une des revendications précédentes, **caractérisé en ce que** les extrémités de fixation (60', 56") de deux boucles (48', 48") adjacentes sont reliées par des lits de connexion (64) en contact avec la seconde paroi (32).

10. Système de refroidissement (4) selon l'une des revendications précédentes, **caractérisé en ce que** les boucles (48) sont disposées en lignes, le long de motifs ou lignes réguliers et répétitifs (44) parallèles à la direction principale d'étendue (X-X), deux motifs ou lignes réguliers (44', 44") adjacents comportant des boucles (48) ayant des parties continues curvilignes (52) non alignées ou décalées dans une direction transversale (T) perpendiculaire à la direction principale d'étendue (X-X) et parallèle à la seconde paroi (32).

11. Système de refroidissement (4) selon l'une des revendications précédentes, **caractérisé en ce que** deux motifs ou lignes réguliers (44', 44") adjacents comportent des boucles (48) sensiblement symétriques par rapport à des plans médians (M) respectifs, les plans médians (M) des boucles (48) des motifs ou lignes réguliers (44', 44") adjacents étant inclinés sur des côtés opposés des plans perpendiculaires à la seconde paroi (32) et à la direction principale d'étendue (X-X).

12. Système de refroidissement (4) selon l'une des revendications précédentes, **caractérisé en ce que** les parties continues curvilignes (52', 52") de boucles (48', 48") adjacentes de la même ligne (44) se touchent à des points de contact (68) sur le côté opposé à la seconde paroi (32).

13. Système de refroidissement (4) selon l'une des revendications précédentes, **caractérisé en ce que** le système comprend des convecteurs pour un flux d'un liquide de refroidissement, le flux de refroidissement étant guidé parallèlement à la seconde paroi (32) et perpendiculairement à la direction principal d'étendue (X-X) des éléments dissipateurs thermiques (40).

14. Système de refroidissement (4) selon l'une des revendications précédentes, **caractérisé en ce que** les éléments dissipateurs thermiques (40) sont au moins partiellement réalisés à l'aide d'une bande continue conductrice pliée sous la forme d'une boucle (48) et attachée à la seconde paroi (32) aux première et seconde extrémités (56, 60) de chaque boucle (48), ladite bande ayant une section transversale quadrangulaire.

15. Système de refroidissement (4) selon l'une des revendications précédentes, **caractérisé en ce que** les éléments dissipateurs thermiques (40) sont au moins partiellement réalisés à l'aide d'un fil continu conducteur plié sous la forme d'une boucle (48) et attachée à la seconde paroi (32) aux première et seconde extrémités (56, 60) de chaque boucle (48), le fil ayant une section transversale curvilinéaire.

16. Convertisseur de puissance électronique (12) pour la commande d'une machine électrique automobile comprenant un composant électronique (8) à refroidir et un système de refroidissement à liquide (4) selon l'une des revendications 1 à 15, **caractérisé en ce que** le composant électronique (8) à refroidir est associé à la plaque d'échangeur thermique (24) du système de refroidissement par liquide (4).
